(19) Europäisches Patentamt

European Patent Office

Office européen des brevets

(11) **EP 1 482 562 A2**

(12) **EUROPEAN PATENT APPLICATION**

(43) Date of publication:
01.12.2004 Bulletin 2004/49

(51) Int Cl.[7]: **H01L 29/786**

(21) Application number: 04253126.9

(22) Date of filing: 27.05.2004

| | |
|---|---|
| (84) Designated Contracting States: **AT BE BG CH CY CZ DE DK EE ES FI FR GB GR HU IE IT LI LU MC NL PL PT RO SE SI SK TR** Designated Extension States: **AL HR LT LV MK** | (72) Inventors: • **Masuoka, Fujio** **Sendai-shi Miyagi 981-0923 (JP)** • **Sakuraba, Hiroshi** **Sendai-shi Miyagi 980-0000 (JP)** • **Yamamoto, Yasue** **Sendai-shi Miyagi 983-0014 (JP)** |
| (30) Priority: 28.05.2003 JP 2003151177 | |
| (71) Applicants: • **Masuoka, Fujio** **Sendai-shi, Miyagi 981-0923 (JP)** • **Sharp Kabushiki Kaisha** **Osaka-shi, Osaka 545-8522 (JP)** | (74) Representative: **Brown, Kenneth Richard et al** **R.G.C. Jenkins & Co.** **26 Caxton Street** **London SW1H 0RJ (GB)** |

(54) **VERTICAL MOSFET**

(57)     A semiconductor device including: a silicon pillar having a high-resistivity region and first and second highly doped regions sandwiching the high-resistivity region therebetween, the high-resistivity region having an impurity concentration of $10^{17}$ cm$^{-3}$ or less; an insulator surrounding the high-resistivity region; and a conductor surrounding the insulator, wherein the conductor is made of a material which permits a voltage applied to the conductor to control an electric current flowing between the first and second highly doped regions and which has a work function bringing the high-resistivity region to a perfect depletion condition during the flow of the electric current between the first and second highly doped regions.

Fig. 2 (a)          Fig. 2 (b)

EP 1 482 562 A2

## Description

### BACKGROUND OF THE INVENTION

1.Field of the Invention

The present invention relates to a semiconductor device and, more particularly, to a semiconductor device capable of employing a designing method for a device of nanometer scale.

2.Description of Related Art

According to the International Technology Roadmap for Semiconductors (ITRS) 2002 Update, in order to meet a recent demand for speed enhancement and consumption power reduction in LSIs, MOSFETs with a gate length of 20 nm will be required by the year 2009 for LSIs intended for speed enhancement and by the year 2013 for LSIs intended for consumption power reduction. In general, as the gate length of the MOSFET is reduced, such problems are arisen, i.e., a threshold voltage is lowered, a subthreshold swing S that decides a switching characteristic is increased and a Drain-Induced Barrier Lowering (DIBL) effect is enhanced. These problems lead to a decrease in stability of the MOSFET.

There will be an increasing demand for LSIs that can solve the above problems, particularly for LSIs that incorporates a new three-dimensional MOSFET with a three-dimensional gate structure. Such a new three-dimensional MOSFET inhibits a short-channel effect derived from CMOS scaling. In Japanese Unexamined Patent Publication Nos. Hei 4(1992)-264776 and Hei 6(1994)-53513, there have proposed a Double-Gate MOSFET (also referred to as a FinFET) and a Surrounding Gate Transistor (SGT), as examples of the three-dimensional MOSFET.

The SGT is so constructed that a source, a gate and a drain are arranged perpendicularly to a substrate with the gate surrounding a pillar semiconductor layer. The SGT therefore occupies much less area than that a flat-type MOSFET does, and it is highly expected that the SGT will be applied to a DRAM, a Flash EEPROM and a CMOS.

Where a conventional scaling for a MOSFET with a polysilicon gate is applied to a SGT of nanometer scale, it is required that a pillar semiconductor layer (channel) surrounded by a gate contains a high concentration of impurities for controlling a threshold voltage. It is difficult, however, to increase the impurity concentration of the channel, and thus it is difficult to bring the channel surrounded by the gate to a perfect depletion condition. Further, such problems as a decline in drive current arise due to degradation of carrier mobility in the channel.

## SUMMARY OF THE INVENTION

The present invention provides a semiconductor device comprising: a silicon pillar having a high-resistivity region and first and second highly doped regions sandwiching the high-resistivity region therebetween, the high-resistivity region having an impurity concentration of $10^{17}$ cm$^{-3}$ or less; an insulator surrounding the high-resistivity region; and a conductor surrounding the insulator, wherein the conductor is made of a material which permits a voltage applied to the conductor to control an electric current flowing between the first and second highly doped regions and which has a work function bringing the high-resistivity region to a perfect depletion condition during the flow of the electric current between the first and second highly doped regions.

The semiconductor device of the present invention with the above constitution has a good stability, achieves both a low off-current and a high on-current and can employ a device-designing method by which an ULSI (ultra large scale integrated circuit) operating at a very high speed and consuming a very low power can be realized, even if a length of the conductor in a direction of a height of the silicon pillar (gate length) is 70 nm or less, particularly 20 nm or less.

These and other objects of the present application will become more readily apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

Figs. 1 (a) and 1 (b) are views for explaining a difference in a technique for realizing an enhancement-type SGT between the a prior art and the present invention;
Fig. 2(a) is a schematic bird's-eye view of a semiconductor device of the present invention;
Fig. 2(b) is a schematic cross-section taken along a channel length direction of the semiconductor device illustrated in Fig. 2(a);
Fig. 2(c) is a schematic cross-section taken along cut-line I-I' of Fig. 2(a);
Fig. 3(a) is a schematic bird's-eye view of a Fin FET of a prior art;
Fig. 3(b) is a schematic cross-section taken along a channel length direction of the Fin FET illustrated in Fig. 3(a);
Fig. 3(c) is a schematic cross-section taken along cut-line II-II' of Fig. 3(a);
Fig. 4 is a graph illustrating the dependence of threshold voltage on gate length in each of a BI-SGT of the present invention and a BI-DG of a prior art;

Fig. 5 is a graph illustrating the dependence of subthreshold swing S on gate length in each of the BI-SGT of the present invention and a BI-DG of a prior art;

Fig. 6 is a graph illustrating the dependence of DIBL effect on gate length in each of the BI-SGT of the present invention and a BI-DG of a prior art;

Fig. 7 is a graph illustrating the dependence of DIBL effect on each of silicon pillar diameter (BI-SGT: present invention) and silicon pillar thickness (BI-DG: prior art);

Fig. 8 is a graph (plotted with a log scale) illustrating the drain current versus gate voltage characteristics in the BI-SGT of the present invention and a BI-DG of a prior art;

Fig. 9 is a graph (plotted with a linear scale) illustrating the drain current versus gate voltage characteristics in the BI-SGT of the present invention and a BI-DG of a prior art;

Fig. 10 is a graph illustrating the on-current versus off-current characteristics in the BI-SGT of the present invention and a BI-DG of a prior art;

Fig. 11 is a graph illustrating a relation of the gate work function and the off-current in each of the BI-SGT of the present invention and a BI-DG of a prior art;

Fig. 12 is a graph illustrating the relation between the surface electric field and the electron mobility of a MOSFET structure;

Fig. 12 (A) is a band-gap diagram showing that when an applied gate voltage equal to or greater than a threshold voltage causes an electric current to flow, a charge-neutral region is created in a p-type region;

Fig. 12(B) is a band-gap diagram showing that when the applied gate voltage equal to or greater than the threshold voltage causes the electric current to flow, the p-type region is perfectly depleted;

Fig. 13(1) is an energy-band diagram of the BI-SGT of the present invention before a gate and a gate insulating film are contacted with a silicon pillar;

Fig. 13(2) is an energy-band diagram of the BI-SGT of the present invention when a gate voltage is 0 V;

Fig. 13(3) is an energy-band diagram of the BI-SGT of the present invention when the gate voltage has a value at which a p⁻-type region surrounded by the gate is just perfectly depleted;

Fig. 13(4) is an energy-band diagram of the BI-SGT of the present invention when a potential of the p⁻-type region is shifted parallel in response to the gate voltage;

Fig. 13(5) is an energy-band diagram of the BI-SGT of the present invention when the p⁻-type region is strongly inverted to cause an electric current to flow and when the p⁻-type region is perfectly depleted;

Fig. 14(1) is an energy-band diagram of the BI-SGT of the present invention before the gate and the gate insulating film are contacted with the silicon pillar;

Fig. 14(2) is an energy-band diagram of the BI-SGT of the present invention when the gate voltage is 0 V;

Fig. 14(3) is an energy-band diagram of the BI-SGT of the present invention when the gate voltage has a value at which the p⁻-type region is just perfectly depleted;

Fig. 14(4) is an energy-band diagram of the BI-SGT of the present invention when the potential of the p⁻-type region is shifted parallel in response to the gate voltage;

Fig. 14(5) is an energy-band diagram of the BI-SGT of the present invention when the p⁻-type region is strongly inverted to cause the electric current to flow and when the p⁻-type region is perfectly depleted;

Fig. 15(1) is an energy-band diagram of the BI-SGT of the present invention before the gate and the gate insulating film are contacted with the silicon pillar;

Fig. 15(2) is an energy-band diagram of the BI-SGT of the present invention when the gate voltage is 0 V;

Fig. 15(3) is an energy-band diagram when the gate voltage has a value at which the p⁻-type region is just perfectly depleted;

Fig. 15(4) is an energy-band diagram of the BI-SGT of the present invention when the potential of the p⁻-type region is shifted parallel in response to the gate voltage; and

Fig. 15(5) is an energy-band diagram of the BI-SGT of the present invention when the p⁻-type region is strongly inverted to cause the electric current to flow and when the p⁻-type region is perfectly depleted.

## DESCRIPTION OF THE PREFERRED EMBODIMENTS

According to the present invention, a region of a silicon pillar surrounded by a conductor contains a concentration of impurities as low as $10^{17}$ cm$^{-3}$ or less (Hereafter, the conductor is referred to as a gate, and the region is referred to as a channel). According to the present invention, despite the channel containing such a low concentration of impurities, it is possible to determine the threshold voltage or the off-current $I_{off}$ by changing a work function of a gate material. In conventional semiconductor devices, on the other hand, the threshold voltage or the off-current $I_{off}$ is controlled by changing the impurity concentration of the channel, and thus it is difficult to decrease the impurity concentration to $10^{17}$ cm$^{-3}$ or less.

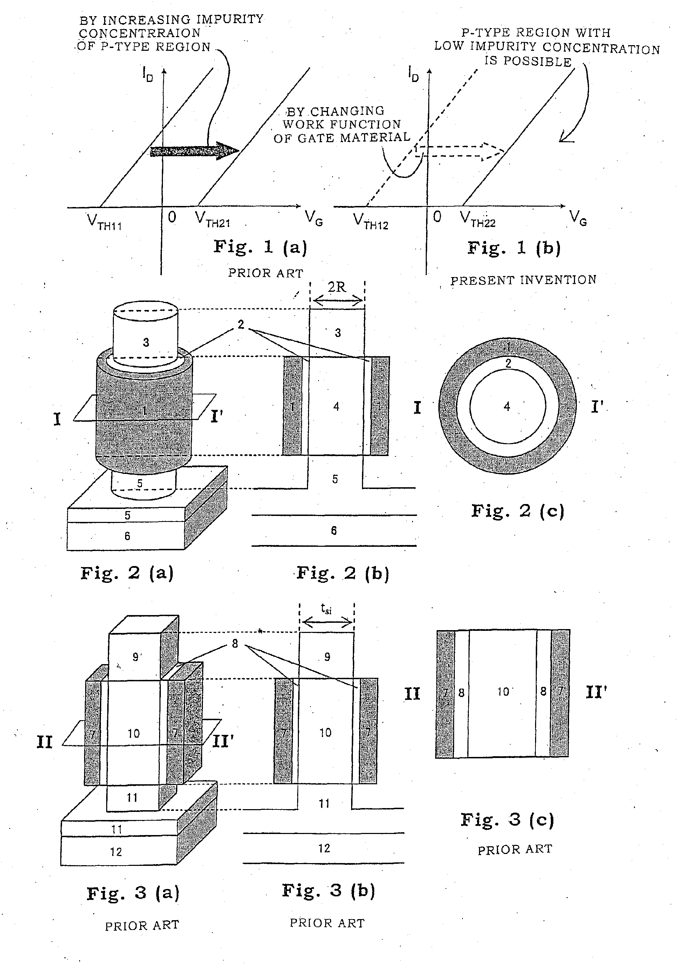

Referring to Figs. 1 (a) and 1 (b), there will be explained a difference in a technique for realizing an enhancement-type SGT between the present invention and a prior art. Here, a gate voltage applied to start an electric current to flow is referred to as a "threshold voltage," and the channel is referred to as a "p-type region."

In prior art, an enhancement-type NMOS transistor with a drain current of 0 A at a gate voltage of 0 V is attained by increasing the impurity concentration of the channel, while in the present technique, it is achieved by changing the work function of the gate material. The present invention, therefore, can reduce the impurity concentration of the channel to as low as $10^{17}$ $cm^{-3}$ or less, thus increasing the resistivity of the channel, and can realize a high mobility of carriers. Consequently, the present invention can alleviate degradation in drive current. The impurity concentration of the channel is preferably $10^{10}$ $cm^{-3}$ to 1017 $cm^{-3}$.

Exemplary p-type impurities contained in the channel include boron and boron fluoride, and exemplary n-type impurities include phosphorus and arsenic.

In the present invention, the threshold voltage or the off-current $I_{off}$ is determined by changing the work function of the gate material for adjusting the impurity concentration of the channel to $10^{17}$ $cm^{-3}$ or less. The gate material is not particularly limited so long as it has a desired work function. Examples of the gate material include molybdenum silicide ($MoSi_2$), tungsten silicide ($WSi_2$) and nickel silicide ($NiSi_2$).

More specifically, for a NMOS transistor, it is preferable to employ a gate material with a work function of 4.668 eV so that an off-current $I_{off}$ of $10^{-12}$ A/$\mu$ m is realized when the silicon pillar has a diameter of 10 nm, the gate length is 20 nm and the thickness (oxide-film equivalent thickness) of the insulator (gate insulating film) is 1 nm. Molybdenum silicide may be mentioned as such a material.

For a PMOS transistor, it is preferable to employ a gate material with a work function of 4.789 eV so that an off-current $I_{off}$ of $10^{-12}$ A/$\mu$ m is realized when the silicon pillar diameter is 10 nm, the gate length is 20 nm and the thickness (oxide-film equivalent thickness) of the insulator is 1 nm. Molybdenum silicide may be mentioned as such a material.

Molybdenum silicide can vary the work function from 4.6 eV to 4.8 eV.

The work function of molybdenum silicide may be adjusted by changing the constituent ratio of molybdenum to silicon or by changing, before silicification, the concentration of impurities doped in polysilicon.

Where the channel is formed as a high-resistivity region containing a concentration of impurities of $10^{17}$ $cm^{-3}$ or less, punchthrough may occur to degrade a controllability of the gate over the channel so that a stable operation is prevented. In such a case, by reducing the silicon pillar diameter (thickness in the case of a prism silicon pillar), a capacity between either the first or second highly doped region (source or drain) and the channel, the cause of the punchthrough, is reduced, thereby improving the controllability of the gate over the channel. Thus, controlling the silicon pillar diameter assists the gate length to be reduced significantly according to scaling rules.

Where the impurity concentration of the channel is $10^{17}$ $cm^{-3}$ or less and the gate length is 70 nm or less, the silicon pillar diameter is preferably 0.7 to 35nm, and where the gate length is 20 nm or less, the gate length is preferably 0.2 to 10 nm.

By perfectly depleting the region of the silicon pillar corresponding to the channel, the subthreshold swing S that decides the switching characteristic will have an ideal value. As a result, the off-current can be reduced, resulting in a semiconductor device capable of operating with a high current.

More specifically, the present invention can provide a semiconductor device capable of realizing such scaling to a gate length of 70 nm or less, particularly 20 nm or less that permits the semiconductor device to operate at a high speed and also to consume a low power. Further, the present invention can be applied not only to a semiconductor device with a gate length of 70 nm or less but also to a semiconductor device with a gate length of more than 70 nm.

The construction of the present semiconductor device will be further explained below. The present semiconductor device comprises a silicon pillar having a high-resistivity region (channel) and first and second highly doped regions (source/drain) sandwiching the high-resistivity region therebetween; an insulator (gate insulating film) surrounding the high-resistivity region and a conductor (gate) surrounding the insulator. The gate permits a voltage applied thereto to control an electric current flowing between the source/drain.

The same impurities are usable for the source/drain as for the channel, and usually, impurities doped into the source/drain have a conductivity-type opposite to that of impurities doped into the channel. The impurity concentrations of the source/drain each are about $10^{18}$ $cm^{-3}$ to $10^{22}$ $cm^{-3}$, though they vary depending on desired characteristics of the semiconductor device,

The gate insulating film is not particularly limited, therefore a known material can be used for its film. Examples of such a gate insulating film include films with a high dielectric constant such as a silicon oxide film, a silicon nitride film, a laminate film of these films (more specifically, an ONO film, etc.), a silicon oxynitride film, an aluminum oxide film, a titanium oxide film, a tantalum oxide film and a hafnium oxide film. The thickness (oxide-film equivalent thickness) of the gate insulating film is preferably 0.1 to 10 nm.

The shape and the size of the silicon pillar are not particularly limited, and may be any necessary to provide a semiconductor device having desired characteristics. Examples of the shape include cylinder, prism (in the case of prism, the silicon pillar may have a triangle, square or polygon cross-section taken along the substrate) and conifer. Further, a plurality of semiconductor devices may be arranged in one silicon pillar. In such a case, the silicon pillar has a height that permits the plurality of semiconductor devices to exist.

More specifically, the silicon pillar preferably has a diameter half the gate length or smaller, and more preferably, has a diameter ranging from one-hundredth of the gate length or greater to half the gate length or smaller.

The present invention will now be explained in detail based on the preferred embodiment shown in the drawings. It should be understood that the present invention is not limited to the embodiment.

Fig. 2(a) is a schematic bird's-eye view of the semiconductor device (SGT structure of perfect-depletion type) of the present invention. Fig. 2(b) is a schematic cross-section taken along a channel length direction of the semiconductor device illustrated in Fig. 2(a). Fig. 2(c) is a schematic cross-section taken along cut-line I-I' of Fig. 2(a).

The semiconductor device of Fig. 2(a) comprises a silicon oxide film 6, a silicon pillar formed on the silicon oxide film 6, a gate insulating film 2, and a gate 1 surrounding the gate insulating film 2. The silicon pillar includes a first highly doped region 3, a high-resistivity region 4 having an impurity concentration of $10^{17}$ cm$^{-3}$ or less, and a second highly doped region 5. The high-resistivity region 4 is surrounded by the gate insulating film 2. A current flowing between the first highly doped region 3 and the second highly doped region 5 is controlled by a voltage applied to the gate 1. The gate 1 is made of a material having a work function which enables the high-resistivity region 4 to be perfectly depleted while an electric current is flowing between the first highly doped region 3 and the second highly doped region 5. The present invention will be explained with reference to this semiconductor device of Fig. 2(a) as an example.

In order to show its advantages, the present invention will be compared with a Fin FET, which also has been drawing attention as another MOSFET with a three-dimensional structure. Fig. 3(a) is a schematic bird's-eye view of the Fin FET to be compared. Fig. 3(b) is a schematic cross-section taken along a channel length direction of the Fin FET illustrated in Fig. 3(a). Fig. 3(c) is a schematic cross-section taken along cut-line II-II' of Fig. 3(a). In Fig. 3(a), reference numeral 7 denotes a gate, 8 denotes a gate insulating film, 9 denotes a first highly doped region, 10 denotes a high-resistivity region of rectangular parallelepiped having an impurity concentration of $10^{17}$ cm$^{-3}$ or less, 11 denotes a second highly doped region, and 12 denotes a silicon oxide film. The first highly doped region 9, the high-resistivity region 10 of rectangular parallelepiped and the second highly doped region 11 constitute a silicon pillar.

Hereafter, the semiconductor device of the present invention is referred to as a Body Intrinsic Surrounding Gate Transistor (BI-SGT), while the Fin FET for comparison with the semiconductor device of the present invention is called a Body Intrinsic Double Gate MOSFET (BI-DG).

Explanations will be made on the results of comparison of the BI-SGT of the present invention with the BI-DG in electric characteristics using a three-dimensional device simulator manufactured by Silvaco Co,. Ltd. 社. As below, the results show that the BI-SGT has superior characteristics over the BI-DG.

It is necessary that the impurity concentrations of the high-resistivity region 4 (BI-SGT) and the high-resistivity region 10 of rectangular parallelepiped (BI-DG) be each set to $10^{17}$ cm$^{-3}$ or less so that decrease in mobility of carriers in the respective devices is inhibited. In the three-dimensional device simulation, it is assumed that the impurity concentrations of the high resistivity regions are zero.

The gate 1 (BI-SGT) and the gate 7 (BI-DG) are each a metal gate or a metal silicide gate. The gate insulating film 2 (BI-SGT) and the gate insulating film 8 (BI-DG) each have a thickness of 1 nm. This value of 1 nm, which is an oxide-film equivalent thickness, is appropriate in terms of the generation of a gate length of 20 nm, and it is more preferable to use a film having a higher dielectric constant so that the gate insulating film can have a greater physical thickness.

Electric characteristics of the BI-SGT and the BI-DG are evaluated by conducting the three-dimensional device simulation on the BI-SGT and the BI-DG each with gate lengths of 10, 20, 30, 40, 50, 60, 70, 80, 90, 100 and 200 nm for each of the lengths of the gate 1 (gate length of the BI-SGT) and the gate 7 (gate length of the BI-DG) when the diameter of a region of the silicon pillar corresponding to the high-resistivity region 4 (hereafter, referred to simply as the silicon pillar diameter) (BI-SGT) and the thickness of a region of the silicon pillar corresponding to the high-resistivity region 10 of rectangular parallelepiped (hereafter, referred to simply as the silicon pillar thickness) (BI-DG) are each 5 nm, 10 nm and 25 nm. The results of the three-dimensional device simulation show that the BI-SGT has excellent characteristic to inhibit the short-channel effect and on-current Ion versus off-current $I_{off}$ characteristic, as described below.

Inhibition of Short Channel Effect

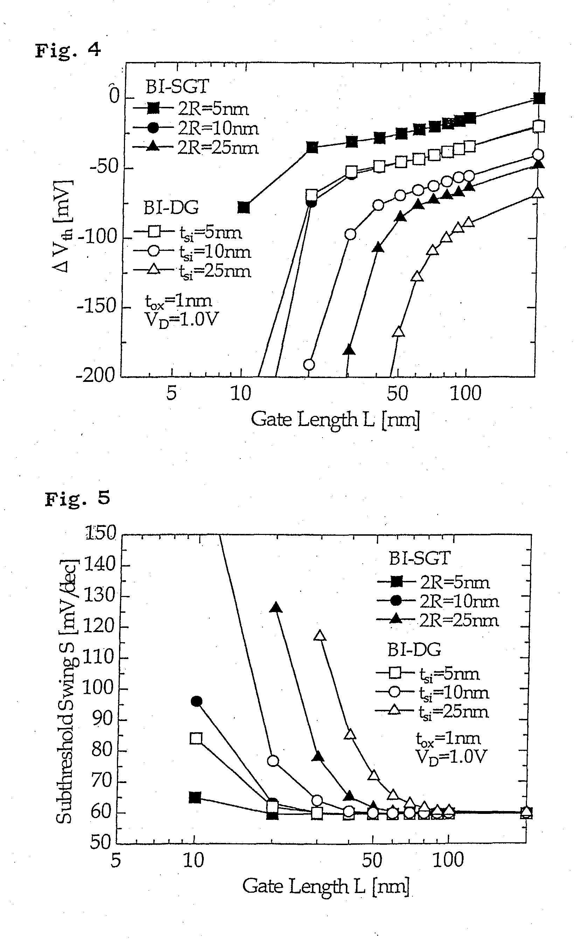

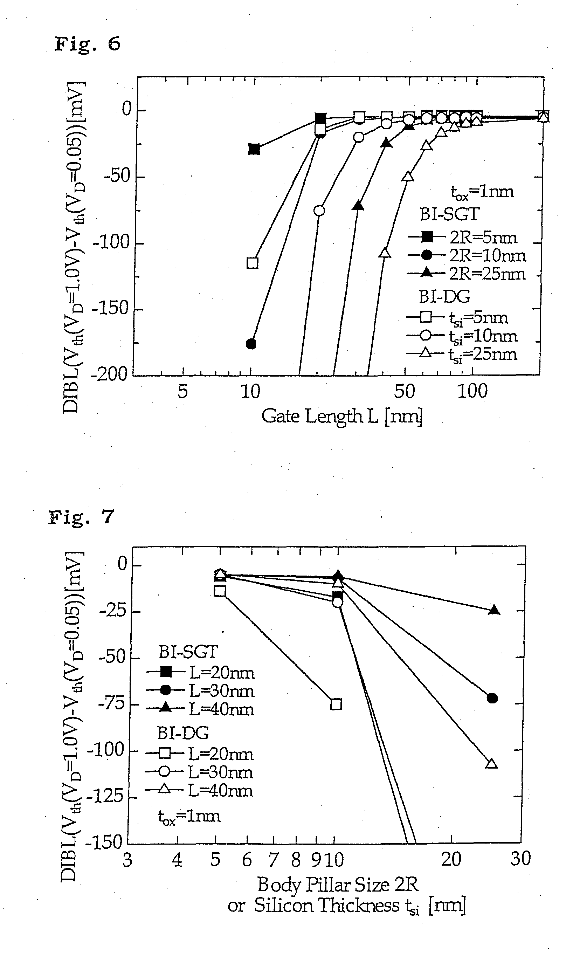

Fig. 4 is a graph illustrating the dependence of threshold voltage on gate length in each of the BI-SGT and the BI-DG. Fig. 5 is a graph illustrating the dependence of subthreshold swing S on gate length in each of the BI-SGT and the BI-DG. Fig. 6 is a graph illustrating the dependence of DIBL effect on gate length in each of the BI-SGT and the BI-DG.

The silicon pillar diameter (BI-SGT) and the silicon pillar thickness (BI-DG) are 5 nm, 10 nm and 25 nm, while the oxide-film equivalent thicknesses of the gate insulating film 2 (BI-SGT) and the gate insulating film 8 (BI-DG) are each 1 nm.

In Fig. 4, it is assumed that a threshold voltage shift $\Delta V_{th}$ has a reference value of zero when the silicon pillar diameter (BI-SGT) is 5 nm. In Fig. 6, the DIBL effect is expressed in a value (DIBL effect value) given by subtracting a threshold voltage obtained at a drain voltage of 0.05 V from a threshold voltage obtained at a drain voltage of 1 V.

Fig. 4 shows that both the BI-SGT and the BI-DG increase the threshold voltage shift $\Delta V_{th}$ with reducing gate length, but also that, when the silicon pillar diameter of the BI-SGT is the same as the silicon pillar thickness of the BI-DG, the BI-SGT inhibits a lowering of the threshold voltage more greatly than the BI-DG by one generation of gate length.

More specifically, the BI-SGT shows excellent characteristics, i.e., a subthreshold swing S of 63 mV/dec and a DIBL effect value of -17 mV where the gate length is 20 nm and the silicon pillar diameter is 10 nm (see: black dots ● in Figs 5 and 6).

On the other hand, the BI-DG shows a subthreshold swing S of 77 mV/dec and a DIBL effect value of -75 mV where the silicon pillar thickness is 10 nm (see: white dots ○ in Figs 5 and 6).

Assuming that the permissible value of subthreshold swing S is 65 mV/dec and the permissible DIBL effect value is - 25 mV, the BI-SGT has a minimum gate length of 20 nm while the BI-DG has a minimum gate length of 30 nm when the silicon pillar diameter (BI-SGT) and the silicon pillar thickness (BI-DG) are each 10 nm.

The BI-SGT in which the channel is surrounded by the gate has a higher controllability of the gate over the channel than the BI-DG in which the channel is interposed between the gates. The BI-SGT, therefore, can more effectively inhibit the short-channel effect (i. e., lowering of threshold voltage, degradation in subthreshold swing S, increase in DIBL effect and the like generated when the gate length becomes shorter), and can realize more aggressive scaling of the gate length than the BI-DG.

More specifically, for inhibiting the short-channel effect and thereby stabilizing the behavior, the BI-SGT with a gate length L may be so designed that the silicon pillar diameter is half the gate length L or smaller where the gate insulating film has an oxide-film equivalent thickness of 1 nm. The BI-DG, on the other hand, must be so designed that the silicon pillar thickness is one thirds of the gate length L. This means that the BI-DG needs to meet severer process requirements than the BI-SGT when the BI-DG is intended to realize the same gate length as the BI-SGT.

Fig. 7 is a graph illustrating the dependence of DIBL effect on each of silicon pillar diameter (BI-SGT) and silicon pillar thickness (BI-DG). The gate lengths of the BI-SGT and the BI-DG each are 20 nm, 30 nm and 40 nm.

Fig. 7 shows that each of the BI-SGT and BI-DG reduces the DIBL effect with decreasing silicon pillar diameter (BI-SGT) or silicon pillar thickness (BI-DG). More specifically, by decreasing the silicon pillar diameter (BI-SGT) or silicon pillar thickness (BI-DG), capacities between the source/drain and channel are each decreased, and thereby the controllability of the channel over the gate can be improved. Thus, decreasing the silicon pillar diameter (BI-SGT) or silicon pillar thickness (BI-DG) is critically important in inhibiting the short-channel effect. Further, if the BI-SGT employs a cylindrical silicon pillar, the BI-SGT has a higher controllability of the channel over the gate than the BI-DG whose silicon pillar is of rectangular parallelepiped and can inhibit the DIBL effect more effectively than the BI-DG.

## On-current $I_{on}$ versus Off-current $I_{off}$ Characteristic and Threshold Voltage Control

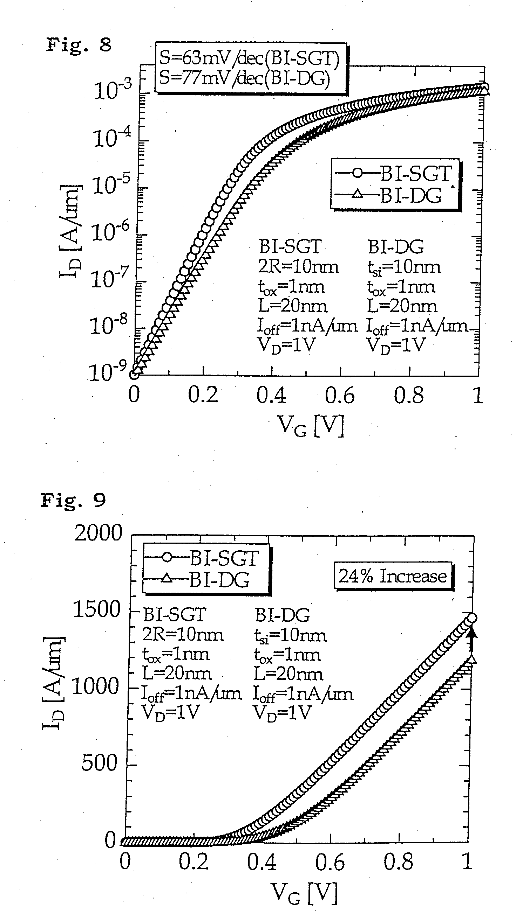

Figs. 8 and 9 are graphs illustrating the drain current versus gate voltage characteristics ($I_d$-$V_g$ characteristics). Fig. 8 is plotted with a log scale and Fig. 9 is plotted with a linear scale. In the BI-SGT, the gate length is 20 nm and the silicon pillar diameter is 10 nm, while in BI-DG, the gate length is 20 nm and the silicon pillar thickness is 10 nm. The off-current $I_{off}$ is defined as a drain current per unit channel width obtained when the gate voltage Vg is 0 V, and the on-current Ion is defined as a drain current per unit channel width obtained when the gate voltage $V_g$ and the drain voltage $V_d$ each are 1 V. This time, the off-current $I_{off}$ is set to 1 nA/$\mu$m in both the BI-SGT and the BI-DG.

Where the gate voltage and the drain voltage are each 1 V ($V_g$=$V_d$=1 V), the on-current Ion of the BI-STG is 1.24 times as large as that of the BI-DG (see Fig. 9). The BI-STG has a subthreshold swings S of 63 mV/dec, while the BI-DG has a subthreshold swings S of 77 mV/dec (see Fig. 8).

Thus, the high drive-performance of the BI-SGT is attributed to the almost ideal subthreshold swing S (an ideal subthreshold swing S indicative of perfect depletion is 60 mV/dec). Therefore, the BI-SGT can realize a CMOS design with high speed and low power consumption.

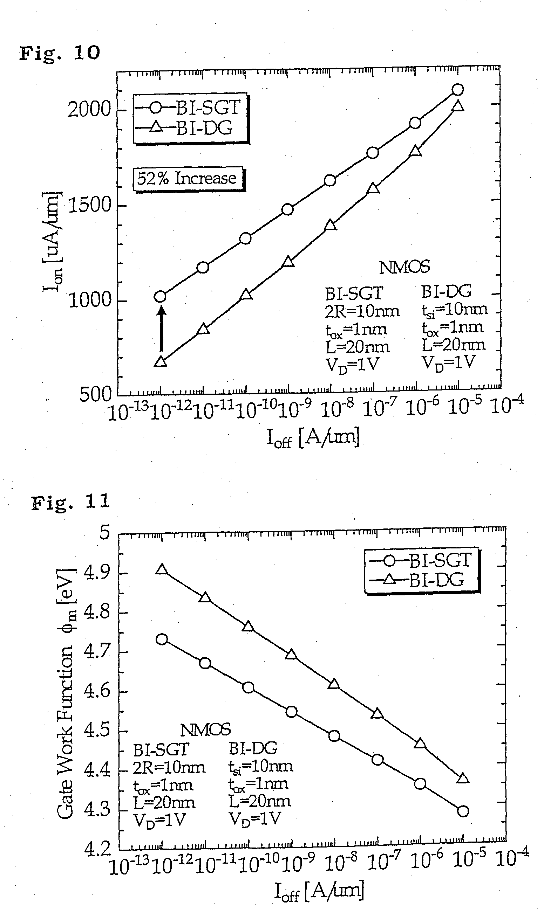

Fig. 10 is a graph illustrating the on-current Ion versus off-current $I_{off}$ characteristics in the BI-SGT and the BI-DG. More specifically, Fig. 10 shows the dependence of on-current Ion on off-current $I_{off}$ in each of the BI-SGT and the BI-DG. In the BI-SGT, the silicon pillar diameter is 10 nm, the oxide-film equivalent thickness of the gate insulating film is 1 nm, the gate length is 20 nm and the drain voltage is 1 V, while in the BI-DG, the silicon pillar thickness is 10 nm, the oxide-film equivalent thickness of the gate insulating film is 1 nm, the gate length is 20 nm and the drain voltage is 1 V.

According to Fig. 10, on-current Ion of the BI-SGT can be compare with on-current Ion of the BI-DG when the BI-SGT and the BI-DG have the same off-current $I_{off}$. When the off-current $I_{off}$ is $10^{-12}$ A/$\mu$m, for instance, the on-current Ion of the BI-SGT is 1.52 times as large as that of the BI-DG. This is due to the fact that while the BI-SGT has the almost ideal subthreshold swing S, the BI-DG has the subthreshold swing S of 77 mV/dec.

As the off-current $I_{off}$ is increased, the difference in on-current Ion between the BI-SGT and the BI-DG narrows. Where the BI-SGT and the BI-DG are so designed that the off-current $I_{off}$ is $10^{-6}$ A / $\mu$ m, the on-current $I_{on}$ of the BI-SGT is only 1.05 times as large as that of the BI-DG, since if the BI-SGT is designed to provide such a high off-current $I_{off}$, it becomes difficult for the BI-SGT to obtain an ideal subthreshold swing S in a subthreshold region.

By setting a low off-current $I_{off}$ with the use of an ideal subthreshold swing, the merits of the BI-SGT can be fully utilized. Also, by using the BI-SGT, a high on-current $I_{on}$ of 1170 $\mu$A/$\mu$ m can be realized together with a low off-current $I_{off}$ of $10^{-12}$ A/ $\mu$ m. Thus, the BI-SGT can provide a CMOS design with high speed and low power consumption.

Fig. 11 is a graph illustrating a relation of the gate work function and the off-current in each of the BI-SGT and the BI-DG. In the BI-SGT, the silicon pillar diameter is 10 nm, the oxide-film equivalent thickness of the gate insulating film is 1 nm, the gate length is 20 nm and the drain voltage is 1 V, while in the BI-DG, the silicon pillar thickness is 10 nm, the oxide-film equivalent thickness of the gate insulating film is 1 nm, the gate length is 20 nm and the drain voltage is 1 V. Fig. 11, shows that, by employing a gate material with a work function ranging from 4.2 eV to 4.8 eV, the BI-SGT with a gate length of 20 nm can be realized.

More specifically, for designing a NMOSFET with an off-current $I_{off}$ of $10^{-12}$ A / $\mu$ m, a gate material with a work function of 4.668 eV may be used when, in the NMOSFET, the silicon pillar diameter is 10 nm, the oxide-film equivalent thickness of the gate insulating film is 1 nm, and the gate length is 20 nm. Examples of such a gate material include molybdenum silicide ($MoSi_2$).

For designing a PMOSFET with an off-current $I_{off}$ of $10^{-12}$ A/$\mu$ m, on the other hand, a gate material with a work function of 4.789 eV may be used when, in the PMOSFET, the silicon pillar diameter is 10 nm, the oxide-film equivalent thickness of the gate insulating film is 1 nm, and the gate length is 20 nm. Examples of such a gate material include molybdenum silicide ($MoSi_2$).

Molybdenum silicide ($MoSi_2$) can vary the work function from 4.6 eV to 4.8 eV.

As has been described, the threshold voltage or the off-current $I_{off}$ in the BI-SGT can be determined by the work function of the gate.

Perfect Depletion of High Resistivity Region Surrounded by Gate during Flow of Electric Current

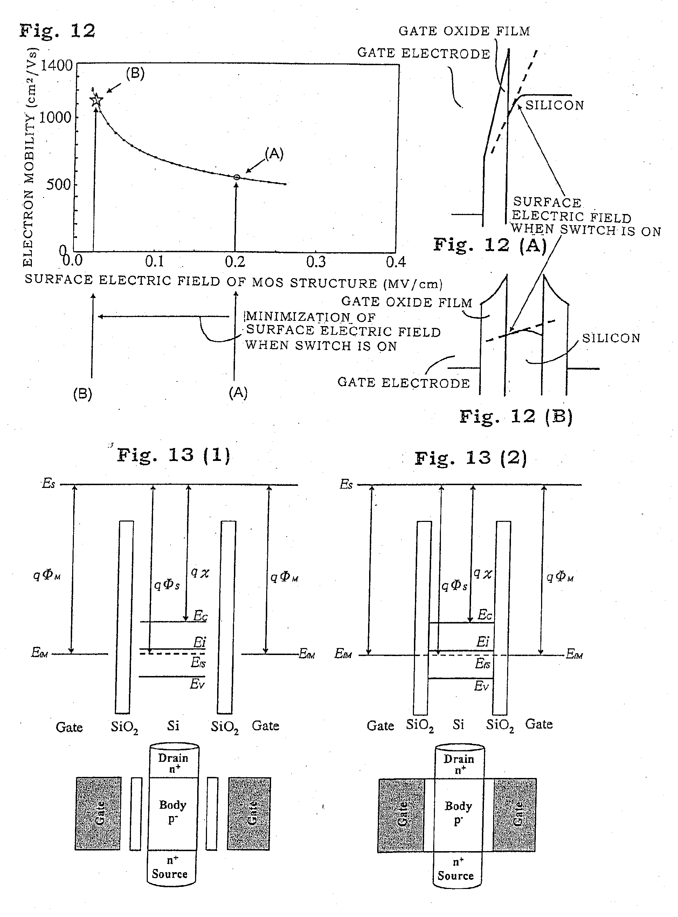

Fig. 12 is a graph illustrating the relation between the surface electric field and the electron mobility of a MOSFET structure. Fig. 12(A) is a band-gap diagram showing that a charge-neutral region is created in a p-type region (high resistivity region) when an applied gate voltage equal to or greater than the threshold voltage causes the electric current to flow. Fig. 12(B) is a band-gap diagram showing that the p-type region is perfectly depleted when the applied gate voltage equal to or greater than the threshold voltage causes the electric current to flow. Here, the surface electric field of the MOS structure means an electric field that is applied in a direction perpendicular to the interface between the gate oxide film and the channel in the SGT structure of perfect-depletion type of the present invention shown in the schematic cross-section of Fig. 2(b).

Fig. 12 shows that electron mobility increases with decreasing surface electric field of the MOS structure. Current I flowing through the channel is expressed by the equation:

$$I=qn\mu \, ES,$$

wherein q is the quantity of an elementary charge, n is the electron density, $\mu$ is the electron mobility, E is the electric field in a direction of electric current, and S is the cross-section area of the channel. That is, the current flowing through the channel is proportional to the electron mobility. Therefore, the current flowing through the channel increases with decreasing surface electric field of the MOS structure.

In the BI-SGT of the present invention, comparing the case where a charge-neutral region is created in a p-type region (high resistivity region) when an applied gate voltage equal to or greater than the threshold voltage causes the electric current to flow (Fig. 12 (A)), with the case where the p-type region is perfectly depleted when an applied gate voltage equal to or greater than the threshold voltage causes the electric current to flow (Fig. 12(B)), the surface electric field of the MOS structure in the former case is smaller than that in the latter case. Therefore, the BI-SGT of the present invention can improve the electron mobility, and as a result, can increase the electric current flowing through the channel, i.e., drive current.

There will be described a mechanism of an energy band of the BI-SGT of the present invention. Which one of a flat-band condition, an accumulation condition and a depletion condition is assumed by the energy band when the gate voltage is 0 V is determined depending on a relation of magnitude between the gate work function $\phi_M$ and the semiconductor work function $\phi_S$ ($\phi_M > \phi_S$, $\phi_M = \phi_S$ or $\phi_M < \phi_S$). A behavior mechanism of a perfect depletion that serves as a key point after the depletion condition is created by increasing the gate voltage is the same as aforementioned.

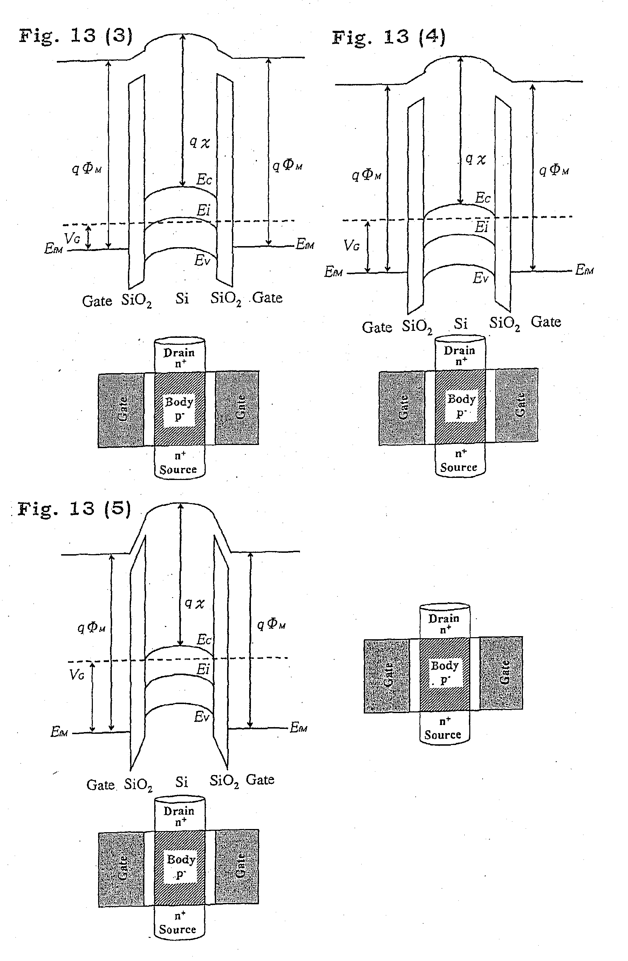

Figs. 13(1) to 13(5) are energy-band diagrams of the BI-SGT of the present invention when the impurity concentration of a p$^-$-type region (high resistivity region) is $10^{15}$ cm$^{-3}$ and the gate work function $\phi_M$ is equal to the semiconductor work function $\phi_S$ (=4.998 eV). More specifically, Fig. 13(1) is an energy-band diagram before the gate, the gate insulating film ($SiO_2$ film) and the silicon pillar are contacted. Fig. 13(2) is an energy-band diagram when the gate voltage is 0 V. Fig. 13(3) is an energy-band diagram when the gate voltage has a value at which the p⁻-type region is just perfectly depleted. Fig. 13(4) is an energy-band diagram when a potential of the p⁻-type region is shifted parallel in response to the gate voltage. Fig. 13(5) is an energy-band diagram when the p⁻-type region is strongly inverted to cause the electric current to flow and when the p⁻-type region is perfectly depleted.

First, the energy band assumes the flat-band condition when the gate voltage is 0 V (see Fig. 13(2)) since the gate work function $\phi_M$ is equal to the semiconductor work function $\phi_S$ (=4.998 eV). As a positive gate-voltage is applied, a depletion layer in the p⁻-type region expands in a concentric configuration to the center of the silicon pillar until the p⁻-type region is just perfectly depleted (see Fig. 13(3)). During the transition from a state shown in Fig. 13(2) to a state shown in Fig. 13(3), the applied gate voltage is divided into two and applied to the gate insulating film and to the p⁻-type region, since electric lines of force emanating from the gate charge is terminated due to ionized impurity atoms present in the p--type region.

As the positive gate-voltage is further increased after the p⁻-type region is perfectly depleted as shown in Fig. 13(3), the electric lines of force emanating from the gate charge fail to be terminated and, because of a gate-capacitance coupling, the entire potential of the p⁻-type region is shifted parallel as shown in Fig. 13(4) by an amount of gate voltage added after the p⁻-type region is just perfectly depleted. The electric field applied to the gate insulating film and the electric field applied to the p⁻-type region at the parallel shift as shown in Fig. 13(4) are not changed from those in the state shown in Fig. 13(3).

As the positive gate-voltage is further increased after the state shown in Fig. 13(4) is reached, carriers begin to be injected from the source into the p⁻-type region so that the electric lines of force emanating from the gate charge begin to be terminated at the carriers injected into the p⁻-type region and then a state shown in Fig. 13(5) is created. The carriers injected into the entire p⁻-type region, however, come to be drawn to a surface of the p⁻-type region at an edge of the source by electrostatic induction of the gate. During the transition from the state shown in Fig. 13(4) to the strong inversion state shown in Fig. 13(5), the potential applied to the p⁻-type region is not changed, and only a potential applied to the gate insulating film is increased.

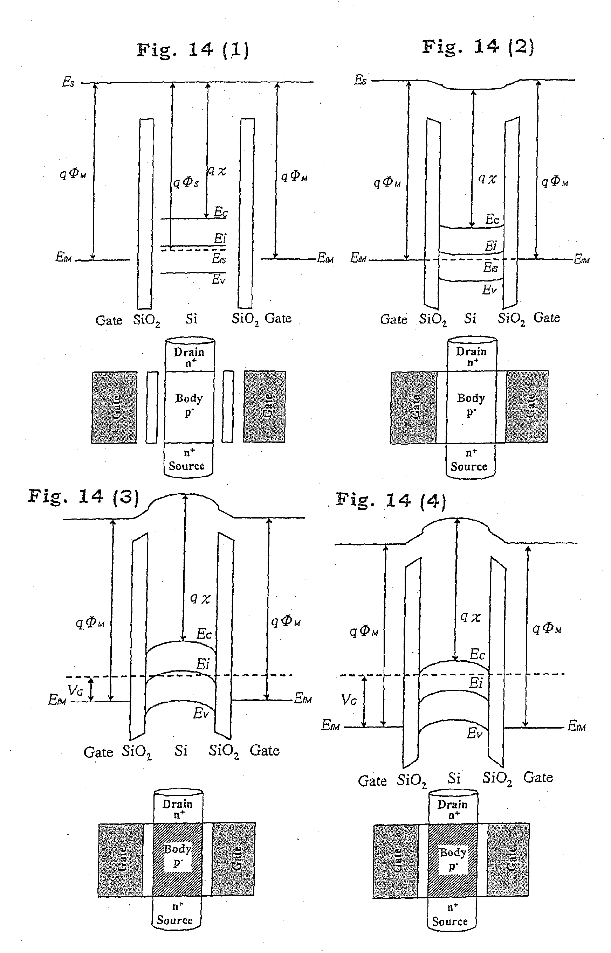

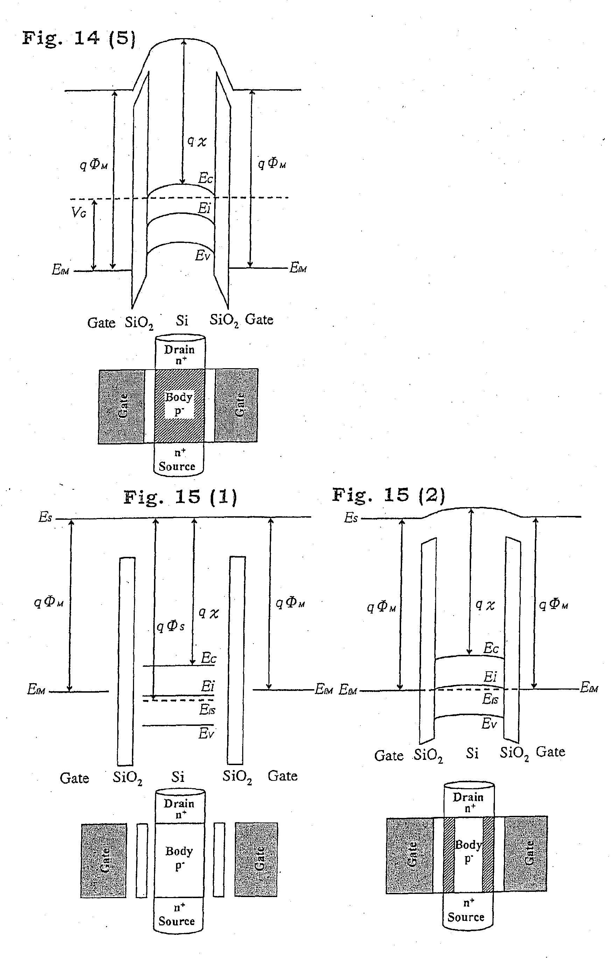

Figs. 14(1) to 14(5) are energy-band diagrams of the BI-SGT of the present invention when the impurity concentration of the p⁻-type region (high resistivity region) is $10^{15}$ cm⁻³ and the gate work function $\phi_M$ is greater than the semiconductor work function $\phi_S$ (=4.998 eV). More specifically, Fig. 14(1) is an energy-band diagram before the gate, the gate insulating film (SiO$_2$ film) and the silicon pillar are contacted. Fig. 14(2) is an energy-band diagram when the gate voltage is 0 V. Fig. 14(3) is an energy-band diagram when the gate voltage has a value at which the p⁻-type region is just perfectly depleted. Fig. 14(4) is an energy-band diagram when the potential of the p⁻-type region is shifted parallel in response to the gate voltage. Fig. 14 (5) is an energy-band diagram when the p⁻-type region is strongly inverted to cause the electric current to flow and when the p⁻-type region is perfectly depleted.

As the positive gate voltage is further increased after the accumulation condition is created at a gate voltage of 0 V as shown in Fig. 14(2), the energy band assumes the flat-band condition. A behavior mechanism after the flat-band condition is assumed is the same as shown in Figs. 14(3) to 14(5).

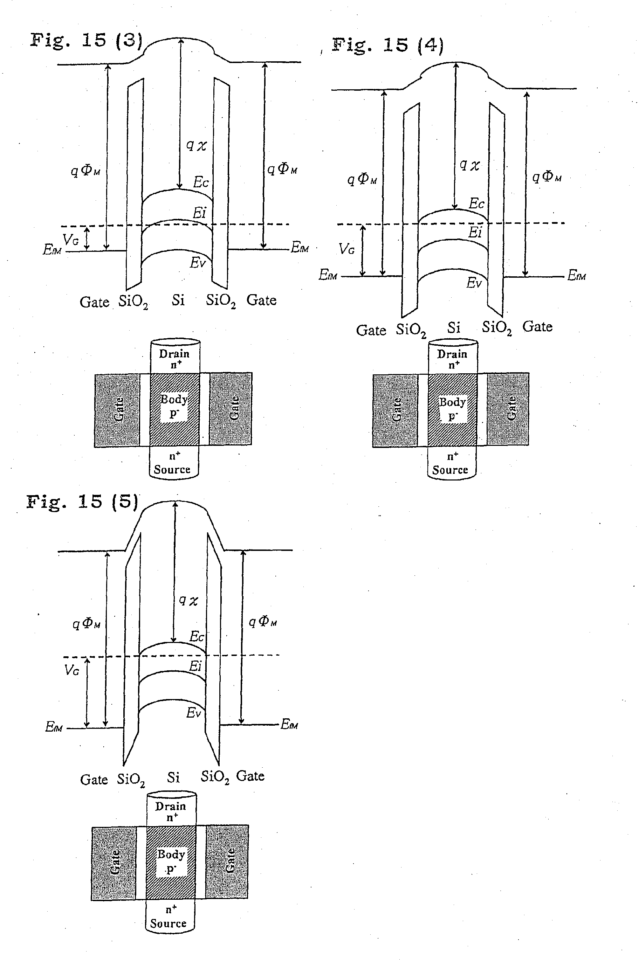

Figs 15(1) to 15(5) are energy band diagrams of the p--type region in the BI-SGT of the present invention when the impurity concentration is $10^{15}$ cm⁻³ and the gate work function $\phi_M$ is smaller than the semiconductor work function $\phi_S$ (=4.998 eV). More specifically, Fig. 15(1) is an energy-band diagram before the gate and the gate insulating film (SiO$_2$ film) are contacted with the silicon pillar. Fig. 15(2) is an energy-band diagram when the gate voltage is 0 V. Fig. 15(3) is an energy-band diagram when the gate voltage has a value at which the p⁻-type region is just perfectly depleted. Fig. 15(4) is an energy-band diagram when the potential of the p⁻-type region is shifted parallel in response to the gate voltage. Fig. 15 (5) is an energy-band diagram when the p⁻-type region is strongly inverted to cause the electric current to flow and when the p⁻-type region is perfectly depleted.

As the positive gate voltage is increased after the depletion condition is assumed at a gate voltage of 0 V as shown in Fig. 15(2), the p⁻-type region is just perfectly depleted. A behavior mechanism after the perfect depletion condition is created is the same as shown in Figs. 13(3) to 13(5).

As has been described above, the present invention can form the channel as a high-resistivity region containing a concentration of impurities of $10^{17}$ cm⁻³ or less by selecting a work function of the gate material. Therefore, the present invention can easily bring the channel to the perfect depletion condition and can optimize the mobility of carriers. Consequently, the present technique can realize a high drive-current.

Further, the present invention can inhibit a lowering of threshold voltage, realize an ideal subthreshold swing S and inhibit an enhancement of the DIBL by reducing the diameter of the silicon pillar even if the gate length is scaled down to 70 nm or less, particularly 20 nm or less. Therefore, the present invention can achieve both a low off-current and a high on-current. The gate length of the semiconductor device of the present invention, however, is not limited to 70 nm or less.

Consequently, the present invention can realize an ULSI operating at a very high speed and consuming a very low power.

## Claims

1. A semiconductor device comprising:

a silicon pillar having a high-resistivity region and first and second highly doped regions sandwiching the high-resistivity region therebetween, the high-resistivity region having an impurity concentration of $10^{17}$ cm$^{-3}$ or less;
an insulator surrounding the high-resistivity region; and
a conductor surrounding the insulator,

wherein the conductor is made of a material which permits a voltage applied to the conductor to control an electric current flowing between the first and second highly doped regions and which has a work function bringing the high-resistivity region to a perfect depletion condition during the flow of the electric current between the first and second highly doped regions.

2. The semiconductor device of claim 1, wherein the high-resistivity region has an impurity concentration of $10^{10}$ cm$^{-3}$ to $10^{17}$ cm$^{-3}$.

3. The semiconductor device of claim 1, wherein the conductor is made of a material with a work function ranging from 4.2 eV to 4.8 eV.

4. The semiconductor device of claim 3, wherein the conductor is made of $MoSi_2$.

5. The semiconductor device of claim 1, wherein the silicon pillar has a diameter half a length of the conductor in a direction of a height of the silicon pillar or smaller.

6. The semiconductor device of claim 5, wherein the silicon pillar has a diameter ranging from one-hundredth of the length of the conductor in the direction of the height of the silicon pillar or greater to half the length or smaller.

7. The semiconductor device of claim 1, wherein the first and second highly doped regions each have an impurity concentration of $10^{18}$ cm$^{-3}$ to $10^{22}$ cm$^{-3}$.

8. A semiconductor device comprising a silicon pillar in which a channel region is disposed lengthwise of the pillar between source and drain regions, wherein a gate insulating film surrounds the channel region, a gate conductor surrounds the gate insulating film, and the gate conductor is arranged to permit a voltage applied thereto to control the flow of an electric current between the source and drain regions.

BY INCREASING IMPURITY
CONCENTRRAION
OF P-TYPE REGION

$I_D$

BY CHANGING
WORK FUNCTION
OF GATE MATERIAL

$V_{TH11}$   0   $V_{TH21}$   $V_G$

**Fig. 1 (a)**

PRIOR ART

P-TYPE REGION WITH
LOW IMPURITY CONCENTRATION
IS POSSIBLE

$I_D$

$V_{TH12}$   0   $V_{TH22}$   $V_G$

**Fig. 1 (b)**

PRESENT INVENTION

2R

3

2

3

1   4   1

5

5

6

I   I'

**Fig. 2 (a)**

**Fig. 2 (b)**

1
2

4

I   I'

**Fig. 2 (c)**

$t_{si}$

9

8

9

8

7   10   7

7   8   10   8   7

11

II   II'

11

II   7   8   10   8   7   II'

11

12

12

**Fig. 3 (a)**

PRIOR ART

**Fig. 3 (b)**

PRIOR ART

**Fig. 3 (c)**

PRIOR ART

Fig. 4

Fig. 5

Fig. 6

Fig. 7

EP 1 482 562 A2

Fig. 8

S=63mV/dec(BI-SGT)
S=77mV/dec(BI-DG)

10⁻³
10⁻⁴
10⁻⁵
10⁻⁶
10⁻⁷
10⁻⁸
10⁻⁹

I_D [A/µm]

—o— BI-SGT
—△— BI-DG

BI-SGT
2R=10nm
t_ox=1nm
L=20nm
I_off=1nA/µm
V_D=1V

BI-DG
t_si=10nm
t_ox=1nm
L=20nm
I_off=1nA/µm
V_D=1V

0    0.2    0.4    0.6    0.8    1

V_G [V]

Fig. 9

2000

—o— BI-SGT
—△— BI-DG

24% Increase

1500

BI-SGT
2R=10nm
t_ox=1nm
L=20nm
I_off=1nA/µm
V_D=1V

BI-DG
t_si=10nm
t_ox=1nm
L=20nm
I_off=1nA/µm
V_D=1V

I_D [A/µm]

1000

500

0

0    0.2    0.4    0.6    0.8    1

V_G [V]

13

Fig. 10

Fig. 11

## Fig. 12

ELECTRON MOBILITY (cm²/Vs)

SURFACE ELECTRIC FIELD OF MOS STRUCTURE (MV/cm)

MINIMIZATION OF SURFACE ELECTRIC FIELD WHEN SWITCH IS ON

(B)  (A)

GATE OXIDE FILM
GATE ELECTRODE
SILICON
SURFACE ELECTRIC FIELD WHEN SWITCH IS ON

## Fig. 12 (A)

GATE OXIDE FILM
SILICON
GATE ELECTRODE

## Fig. 12 (B)

## Fig. 13 (1)

$E_s$

$q\Phi_M$  $q\Phi_S$  $q\chi$  $q\Phi_M$

$E_C$
$E_i$
$E_{fM}$
$E_{fS}$
$E_v$

Gate  SiO$_2$  Si  SiO$_2$  Gate

Drain n⁺
Body p⁻
n⁺ Source
Gate   Gate

## Fig. 13 (2)

$E_s$

$q\Phi_M$  $q\Phi_S$  $q\chi$  $q\Phi_M$

$E_C$
$E_i$
$E_{fM}$
$E_{fS}$
$E_v$

Gate  SiO$_2$  Si  SiO$_2$  Gate

Drain n⁺
Body p⁻
n⁺ Source
Gate   Gate

## Fig. 13 (3)

$q\Phi_M$    $q\chi$    $q\Phi_M$

$E_C$

$E_i$

$V_G$

$E_{fM}$      $E_V$      $E_{fM}$

Gate   SiO$_2$   Si   SiO$_2$   Gate

Drain n$^+$

Gate   Body p$^-$   Gate

n$^+$ Source

## Fig. 13 (4)

$q\Phi_M$    $q\chi$    $q\Phi_M$

$E_C$

$E_i$

$V_G$

$E_{fM}$      $E_V$      $E_{fM}$

Gate   SiO$_2$   Si   SiO$_2$   Gate

Drain n$^+$

Gate   Body p$^-$   Gate

n$^+$ Source

## Fig. 13 (5)

$q\Phi_M$    $q\chi$    $q\Phi_M$

$E_C$

$E_i$

$V_G$

$E_V$

$E_{fM}$           $E_{fM}$

Gate   SiO$_2$   Si   SiO$_2$   Gate

Drain n$^+$

Gate   Body p$^-$   Gate

n$^+$ Source

Drain n$^+$

Gate   Body p$^-$   Gate

n$^+$ Source

16

## Fig. 14 (1)

$E_S$

$q\Phi_M$  $q\Phi_S$  $q\chi$  $q\Phi_M$

$E_C$

$E_i$

$E_{iS}$

$E_{iM}$  $E_{iM}$

$E_V$

Gate  SiO$_2$  Si  SiO$_2$ Gate

Drain
n$^+$

Gate  Body
p$^-$  Gate

n$^+$
Source

## Fig. 14 (2)

$E_S$

$q\Phi_M$  $q\chi$  $q\Phi_M$

$E_C$

$E_i$

$E_{iM}$  $E_{iS}$  $E_{iM}$

$E_V$

Gate  SiO$_2$  Si  SiO$_2$ Gate

Drain
n$^+$

Gate  Body
p$^-$  Gate

n$^+$
Source

## Fig. 14 (3)

$q\Phi_M$  $q\chi$  $q\Phi_M$

$E_C$

$E_i$

$V_G$

$E_{iM}$  $E_{iM}$

$E_V$

Gate  SiO$_2$  Si  SiO$_2$  Gate

Drain
n$^+$

Gate  Body
p$^-$  Gate

n$^+$
Source

## Fig. 14 (4)

$q\Phi_M$  $q\chi$  $q\Phi_M$

$E_C$

$E_i$

$V_G$

$E_{iM}$  $E_V$  $E_{iM}$

Gate  SiO$_2$  Si  SiO$_2$  Gate

Drain
n$^+$

Gate  Body
p$^-$  Gate

n$^+$
Source

17

Fig. 14 (5)

Fig. 15 (1)

Fig. 15 (2)

## Fig. 15 (3)

Gate  SiO$_2$  Si  SiO$_2$  Gate

## Fig. 15 (4)

Gate  SiO$_2$  Si  SiO$_2$  Gate

## Fig. 15 (5)

Gate  SiO$_2$  Si  SiO$_2$  Gate